Europäisches Patentamt

European Patent Office

Office européen des brevets

(19)

(11) Veröffentlichungsnummer : **0 075 884**
**B1**

(12) **EUROPÄISCHE PATENTSCHRIFT**

(45) Veröffentlichungstag der Patentschrift :
09.07.86

(21) Anmeldenummer : 82108843.2

(22) Anmeldetag : 24.09.82

(51) Int. Cl.⁴ : **H 05 K   9/00, H 01 F 27/36,**
**H 01 F 31/08, H 01 T   4/20,**
**G 01 R 31/00**

(54) Hochspannungsabschirmelektrode.

(30) Priorität : 25.09.81 DD 233564

(43) Veröffentlichungstag der Anmeldung :
06.04.83 Patentblatt 83/14

(45) Bekanntmachung des Hinweises auf die Patenterteilung : 09.07.86 Patentblatt 86/28

(84) Benannte Vertragsstaaten :
CH DE GB IT LI SE

(56) Entgegenhaltungen :
DE-A- 2 144 498
US-A- 3 070 646
US-A- 3 745 226
BULLETIN DES SCHWEIZERISCHEN ELEKTROTECH-
NISCHEN VEREINS, Band 63, Nr. 11, 27. Mai 1972, H.
SINGER: "Das elektrische Feld von Polycon-Elektroden"
REVUE DE PHYSIQUE APPLIQUEE, Band 5, Nr. 1,
Februar 1970, D. COHEN: "Large-volume conventional magnetic shields"

(73) Patentinhaber : VEB Transformatoren- und Röntgenwerk "Hermann Matern"
Overbeckstrasse 48
DDR-8030 Dresden (DD)

(72) Erfinder : Dietrich, Martin, Dipl.-Ing.
Georg-Palitzsch-Strasse 71
DDR-8036 Dresden (DD)
Erfinder : Schufft, Wolfgang, Dipl.-Ing.
Am grünen Grund 4
DDR-8080 Dresden (DD)
Erfinder : Hartmann, Roland
Buchholzer Strasse 2
DDR-8023 Dresden (DD)

(74) Vertreter : Patentanwälte Beetz sen. - Beetz jun.
Timpe - Siegfried - Schmitt-Fumian
Steinsdorfstrasse 10
D-8000 München 22 (DE)

EP 0 075 884 B1

## Beschreibung

Die Erfindung betrifft eine Hochspannungsabschirmelektrode mit einem auf ein Hochspannungsgerät aufsetzbaren gitterartigen Traggestell, dessen Oberfläche mit einer Vielzahl tellerförmiger Elektroden belegt ist. Sie betrifft ferner eine besonders zweckmäßige Gestaltung einer solchen Tellerelektrode.

Für die teilentladungsfreie Gestaltung von Hochspannungsprüfanlagen sind Abschirmelektroden mit Abmessungen von mehreren Metern erforderlich. Die Herstellung solch großflächiger Elektroden stößt mit steigenden Spannungen und in Abhängigkeit von der Spannungsform auf zunehmende technologische Schwierigkeiten. Es ist daher bekannt, derartige großflächige Abschirmelektroden aus einer Vielzahl nahe beieinander angeordneter tellerförmiger Elektroden zu bilden.

Ein Traggestell für die Tellerelektroden dieser sogenannten Polygonelektroden ist aus der DE-OS 2 144 498 bekannt. Es ist aus Horizontalringen und Meridianteilringen aufgebaut, die ein Gestell in Gestalt einer Kugelkalotte bilden. An den Meridianteilringen sind in gleichmäßigem Abstand Horizontalringe befestigt. Das Meridian-Horizontalringsystem wird von einem Stützsystem getragen. Die Tellerelektroden sind an den Horizontalringen lösbar befestigt. Die Befestigung erfolgt dabei derart, daß an Innenflächen der Tellerelektroden Gewindebuchsen angelötet und diese von innen durch eine Schraube an der betreffenden Stelle, die eine Durchgangsbohrung aufweist, angeschraubt sind. Für Montagezwecke ist der untere Teil des Traggestells der Hochspannungsabschirmelektrode mit den zugehörigen Tellerelektroden nach außen schwenkbar ausgebildet. Nachteilig ist jedoch, daß das Traggestell relativ kompliziert aufgebaut ist und für jede Elektrodengröße bzw. jeden Elektrodentyp andere Traggestellteile erforderlich sind. Außerdem ist die Verbindung der Tellerelektroden mit der Gewindebuchse technologisch aufwendig sowie die Montage kompliziert bzw. die Anordnungsdichte der Tellerelektroden begrenzt.

Der Erfindung liegt die Aufgabe zugrunde, eine Hochspannungsabschirmelektrode der eingangs genannten Art anzugeben, deren Traggestell aus einfachen Traggestellteilen aufgebaut ist, die für möglichst viele Elektrodengrößen und -typen verwendbar sind, und deren tellerförmige Elektroden bei geeigneter Formgebung leichter als beim Stand der Technik zu befestigen sind.

Diese Aufgabe wird nach dem Kennzeichen des Anspruchs 1 gelöst. Vorteilhafte Weiterbildungen sind Gegenstand der Unteransprüche.

Die tellerförmigen Elektroden besitzen in der Tellermitte eine muldenförmige Vertiefung (Einziehung) mit einer Bohrung, wobei innerhalb der Einziehung ein Befestigungselement zur Halterung am Traggestell vorgesehen ist. Eine günstige Tellergeometrie ergibt sich, wenn der Radius $R_E$ der Einziehung zwischen einem Viertel und der Hälfte des am Tellerrand vorgesehenen Krümmungsradius $R_A$ beträgt, das Verhältnis $R_E/R_A$ entsprechend 0,25 bis 0,5 beträgt.

Zur Erhöhung der Biegefestigkeit sind die Traggestellstreben vorzugsweise in Längsrichtung profiliert.

Vorteilhafterweise besitzt das aus einer Strebenart aufgebaute Traggestell die Form eines Ikosaeders. Für große Hochspannungsabschirmelektroden ist es möglich, lediglich längere Streben und größere Elektroden zu verwenden.

Die durch die Erfindung erzielten Vorteile sind im wesentlichen darin zu sehen, daß aus einfachen Traggestellteilen viele verschiedene Elektrodengrößen und -typen gefertigt werden können. Die erfindungsgemäße Gitterstruktur des Traggestelles ist einfach und mechanisch sehr stabil. Es ist nunmehr auch möglich, die Abschirmelektrode erst am Aufstellungsort aufzubauen. Für die Vereinfachung im Aufbau und bei der Montage der Abschirmelektrode stellt die neuartige Halterung ohne der technologisch aufwendigen Verbindung zwischen Elektrodenteller und beispielsweise einer Gewindebuchse eine wesentliche Bereicherung dar. Damit ist auch eine hohe Anordnungsdichte der Tellerelektroden und eine Montage von außen möglich.

Anhand eines Ausführungsbeispieles soll die Erfindung nachstehend näher erläutert werden. In den zugehörigen Zeichnungen zeigen

Figur 1 eine erfindungsgemäße Hochspannungsabschirmelektrode,

Figur 2 die Form eines Traggestelles für die Hochspannungsabschirmelektrode gemäß Fig. 1,

Figur 3 eine Traggestellstrebe,

Figur 4 eine elliptische Hochspannungsabschirmelektrode und

Figur 5 eine Tellerelektrode im Halbschnitt, die auch für sich vorteilhaft verwendbar ist.

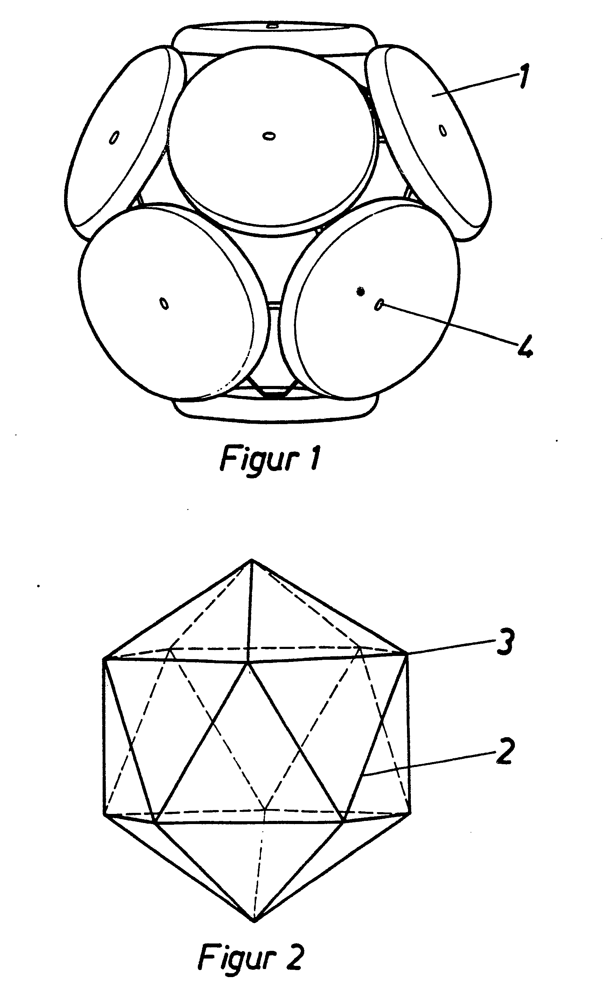

Für Hochspannungsprüfanlagen werden oft Abschirmelektroden kugeliger Gestalt benötigt. In Figur 1 ist eine entsprechende Abschirmelektrode erfindungsgemäßer Ausführung gezeigt. Sie besitzt die Form eines regulären Polyeders (Dodekaeder) und ist mit zwölf Tellerelektroden 1 ausgeführt. Soll die Abschirmelektrode als Kopfelektrode für einen Hochspannungsapparat verwendet werden, entfällt der untere Teller. Das Traggestell besteht aus Streben 2 einer einzigen Art, die untereinander gitterartig verbunden sind und im betrachteten Fall einen Ikosaeder bilden (siehe Figur 2).

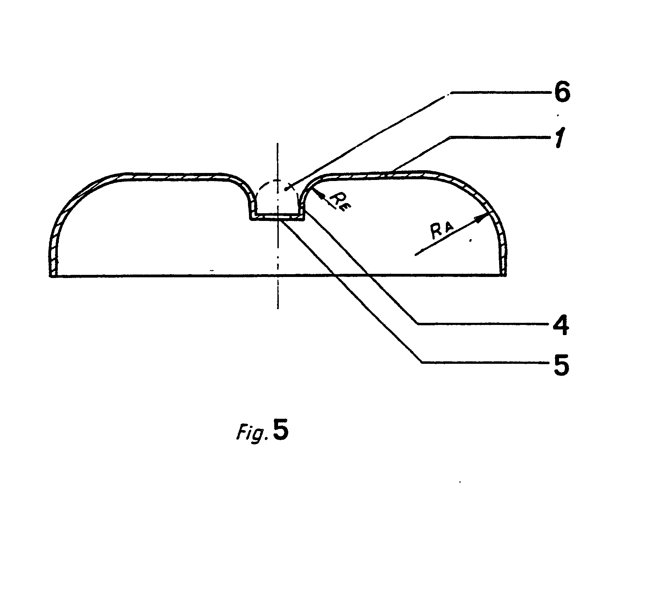

Die Tellerelektroden 1 sind an den Verbindungsstellen 3 der Streben 2 angebracht. Die neuartige Gestaltung der Tellerelektroden 1 ist in Figur 5 gezeigt. Sie ermöglicht die Befestigung der Tellerelektroden 1 von außen, indem jede Tellerelektrode 1 im Bereich ihrer Rotationsachse eine Einziehung 4 mit einer Bohrung 5 aufweist. Innerhalb dieser Einziehung ist Raum zur Aufnahme einer — hier unterbrochen angedeuteten — Hutmutter 6 als Befestigungselement, mit deren Hilfe die Tellerelektrode 1 aufgeschraubt wird. Eine derartige Lösung wird dadurch ermöglicht, daß entgegen allen bisherigen Grundsätzen zur Gestaltung von Elektroden diese nicht so erfolgt, daß die Oberflächenfeldstärke an allen Punkten der Elektrodenoberfläche ein Minimum wird. Vielmehr liegt ihr die überraschende Erkenntnis zugrunde, daß höhere Feldstärken in räumlich eng begrenzten Gebieten zugelassen werden können. Die Durchschlagsstrecke zwischen einer Tellerelektrode 1 und einer Gegenelektrode kann als Parallelschaltung der Teilstrecken ebene Tellerfläche — Gegenelektrode, Tellerrand — Gegenelektrode, Tellereinziehung mit Hutmutter — Gegenelektrode aufgefaßt werden, wobei es möglich ist, durch entsprechende Wahl des Einziehungsradius $R_E$ und des Tellerrandradius $R_A$ für alle Teilstrecken die gleiche bzw. insgesamt eine maximale Durchschlagsspannung einzustellen. Während der Durchmesser einer Tellerelektrode 1 den allgemein aus der Literatur bekannten Vorschlägen folgt, wird für die Radien ein Verhältnis $R_E : R_A = 0,25 ... 0,5$ angestrebt.

Die Einziehung 4 der Tellerelektrode 1 ist so gestaltet, daß sich die Hutmutter 6 innerhalb der Einhüllenden der Tellerelektrode 1 befindet und das Niveau der die Einziehung 4 umgebenden Tellerfläche nicht überragt. Es kann für eine Herabsetzung der Anforderungen an die Hutmutter 6 vorteilhaft sein, diese in einen Isolierstoff einzubetten. Selbstverständlich kann die Befestigung der Tellerelektroden 1 auch durch Schnapp- oder Steckverschlüsse erfolgen. Die Tellerelektroden 1 bestehen vorzugsweise aus Aluminium und stehen als sofort montierbares Massenteil zur Verfügung.

Das beschriebene Traggestell ist durch die Gitterwerkkonstruktion mechanisch sehr stabil. Werden größere Hochspannungsabschirmelektroden benötigt, können Form und Konstruktionsprinzip beibehalten werden. Es sind nunmehr lediglich längere Streben und größere Tellerelektroden, z. B. mit einem Durchmesser von 1 m, zu verwenden.

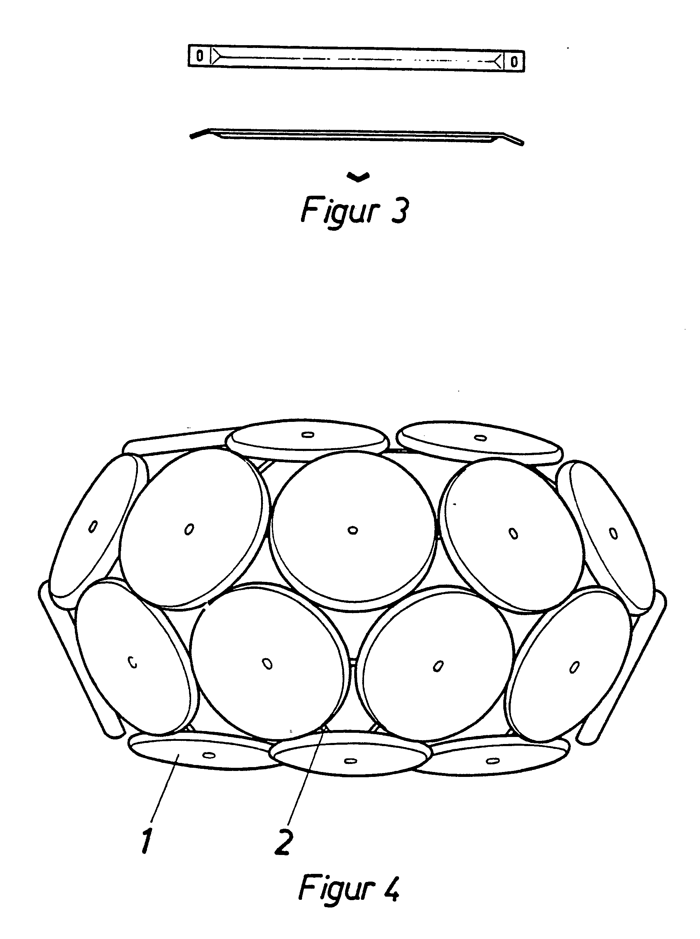

Im Gegensatz zu den bisher üblichen Hochspannungsabschirmelektroden, bei denen mit vielen kleinen Tellerelektroden eine kugelige Gestalt angestrebt wird, verzichtet man bei der beschriebenen Abschirmelektrode auf eine derartige Annäherung und verwendet relativ große Tellerelektroden, die in einem relativ großen Winkel zueinander gestellt sind. Dieses Prinzip ist auch auf andere Formen übertragbar. In Figur 3 ist eine Traggestellstrebe gezeigt, die zur Erhöhung der Biegefestigkeit in Längsrichtung profiliert ist. Figur 4 zeigt eine elliptische Hochspannungsabschirmelektrode mit einem erfindungsgemäß ausgeführten Traggestell. Die Streben bilden dabei hauptsächlich Dreieckkonfigurationen.

**Patentansprüche**

1. Hochspannungsabschirmelektrode mit einem auf ein Hochspannungsgerät aufsetzbaren gitterartigen Traggestell, dessen Oberfläche mit einer Vielzahl tellerförmiger Elektroden (1) belegt ist, dadurch gekennzeichnet,

daß das Traggestell aus untereinander verbundenen geraden Streben (2) besteht,

wobei mindestens größtenteils von den Streben Dreieckkonfigurationen gebildet sind, und

nur an den Verbindungsstellen (3) der Streben (2) mit Ausnahme der Befestigungsstellen des Traggestells auf dem Hochspannungsapparat jeweils eine tellerförmige Elektrode (1) angeordnet ist (Fig. 2).

2. Hochspannungsabschirmelektrode nach Anspruch 1, dadurch gekennzeichnet, daß die tellerförmigen Elektroden (1) je eine muldenförmige Einziehung (4) mit einer Bohrung (5) und innerhalb der Einziehung (4) ein Befestigungselement (6) zur Halterung am Traggestell aufweisen (Fig. 5).

3. Hochspannungsabschirmelektrode nach Anspruch 2, dadurch gekennzeichnet, daß das Verhältnis des Radius $R_E$ der Einziehung (4) und des Radius $R_A$ der Randkrümmung der tellerförmigen Elektroden (1) $R_E/R_A$ 0,25 bis 0,5 beträgt.

4. Hochspannungsabschirmelektrode nach einem der Ansprüche 1 bis 3, dadurch gekennzeichnet, daß das aus Streben (2) aufgebaute Traggestell die Form eines Ikosaeders aufweist.

5. Hochspannungsabschirmelektrode nach einem der Ansprüche 1 bis 4, dadurch gekennzeichnet, daß größere Hochspannungsabschirmelektroden bei gleichem Aufbauprinzip wie bei kleineren Hochspannungsabschirmelektroden mit längeren Streben (2) und größeren tellerförmigen Elektroden (1) aufgebaut sind.

6. Hochspannungsabschirmelektrode nach einem der Ansprüche 1 bis 5, dadurch gekennzeichnet, daß die Streben (2) in Längsrichtung profiliert sind.

**Claims**

1. High-tension shielding electrode, comprising a grid-like supporting frame adapted to be mounted on a high-tension apparatus, the surface of said frame being covered with a multiplicity of dish-shaped electrodes (1), characterised in

that the supporting frame is formed of mutually joined straight braces (2),

at least the majority of said braces constituting triangular configurations, and

a respective dish-shaped electrode (1) being disposed only at the joints (3) of the braces (2) with the exception of the mounting locations of the supporting frame on the high-tension apparatus (Fig. 2).

2. High-tension shielding electrode as claimed in claim 1, characterised in that each of the dish-shaped electrodes (1) includes a throat (4) having a bore (5) and within said throat a fastening element (6) for securing to the supporting frame (Fig. 5).

3. High-tension shielding electrode as claimed in claim 2, characterised in that the ratio of the radius $R_E$ of the throat (4) to the radius $R_A$ of the curvature of the rim of the dish-shaped electrodes (1) $R_E/R_A$ is 0.25 to 0.5.

4. High-tension shielding electrode as claimed in any of the claims 1 to 3, characterised in that the supporting frame composed of braces (2) is icosahedron-shaped.

5. High-tension shielding electrode as claimed in any of the claims 1 to 4, characterised in that larger high-tension shielding electrodes, while being configured on the same structural principle as smaller high-tension shielding electrodes, are constructed with longer braces (2) and larger dish-shaped electrodes (1).

6. High-tension shielding electrode as claimed in any of the claims 1 to 5, characterised in that the braces (2) are contoured in longitudinal direction.

**Revendications**

1. Electrode de blindage pour haute tension, comportant une monture de support en genre de treillis pouvant être placée sur un appareil à haute tension et dont la surface extérieure est occupée par un certain nombre d'électrodes (1) en forme de disques, caractérisée :

en ce que la monture de support est constituée par des étrésillons (2) rectilignes reliés les uns aux autres,

des configurations triangulaires étant formées pour au moins la plupart des étrésillons,

seulement aux endroits de liaison (3) des étrésillons (2), à l'exception des points de fixation de la monture de support sur l'appareil à haute tension, est montée chaque fois une électrode (1) en forme de disque (fig. 2).

2. Electrode de blindage pour haute tension selon la revendication 1, caractérisée en ce que les électrodes (1) en forme de disques, comportent chacune un retrait (4) en forme d'auge pourvu d'un alésage (5) et, à l'intérieur du retrait (4), un élément de fixation (6) pour maintenir l'électrode sur la monture de support (fig. 5).

3. Electrode de blindage pour haute tension selon la revendication 2, caractérisée en ce que le rapport entre le rayon de courbure $R_E$ du retrait (4) et le rayon $R_A$ de la courbure du bord des électrodes (1) en forme de disques $R_E/R_A$ est de 0,25 à 0,5.

4. Electrode de blindage pour haute tension selon l'une des revendications 1 à 3, caractérisée en ce que la monture de support constituée d'étrésillons (2) présente la forme d'un icosaèdre.

5. Electrode de blindage pour haute tension selon l'une des revendications 1 à 4, caractérisée en ce que de relativement grandes électrodes de blindage pour haute tension, selon le même principe de montage que pour de plus petites électrodes de blindage pour haute tension, sont constituées avec des étrésillons (2) relativement longs et des électrodes (1) en forme de disques relativement grandes.

6. Electrode de blindage pour haute tension selon l'une des revendications 1 à 5, caractérisée en ce que les étrésillons (2) sont profilés en direction longitudinale.

Figur 1

Figur 2

0 075 884

Figur 3

1    2

Figur 4

Fig. 5